Europäisches Patentamt

European Patent Office

Office européen des brevets

(11) Publication number: **0 376 207**
**A2**

## EUROPEAN PATENT APPLICATION

(21) Application number: 89123810.7

(22) Date of filing: 22.12.89

(51) Int. Cl.⁵: **B05C 1/08, B05D 1/28**

(30) Priority: 26.12.88 JP 328666/88

(43) Date of publication of application:
04.07.90 Bulletin 90/27

(84) Designated Contracting States:
DE GB NL

(71) Applicant: FUJI PHOTO FILM CO., LTD.
210 Nakanuma Minami Ashigara-shi
Kanagawa(JP)

(72) Inventor: Ishizuka, Seiji Fuji Photo Film Co.,
Ltd.
No. 210 Nakanuma
Minami Ashigara-shi Kanagawa(JP)
Inventor: Saito, Hiroki Fuji Photo Film Co., Ltd.
No. 210 Nakanuma
Minami Ashigara-shi Kanagawa(JP)

(74) Representative: Patentanwälte Grünecker,
Kinkeldey, Stockmair & Partner
Maximilianstrasse 58
D-8000 München 22(DE)

(54) Application device.

(57) A device for applying liquid to a relatively short substrate through the use of a coating bar. The device includes a conveying device for conveying the substrate, a cylindrical bar which is rotatably supported such that the bar is in contact with the substrate, and a motor for rotating the bar such that the outer circumferential portion of the bar in contact with the substrate moves in the same direction as the substrate. Liquid is supplied to the vicinity of the rotating bar such that upon rotation of the bar, the liquid is lifted to create a menisci on the side of the substrate where the bar contacts the substrate and immediately upstream therefrom. In the stationary position, the difference between the height of the surface of the supplied liquid to the height of the top of the bar is 0.5 millimeters to 4.5 millimeters. In this manner, a smooth uniform film is applied to the substrate.

FIG. 1

## APPLICATION DEVICE

### BACKGROUND OF THE INVENTION

Field of the Invention

The present invention relates to a device for applying a liquid to a relatively short substrate through the use of a coating bar. More particularly, the present invention relates to a device for applying a photoresist to a semiconductor wafer; applying a photoresist to a photographic mask for the production of a semiconductor wafer; applying a solder resist to a printed circuit board; applying a liquid to a glass plate; or the like.

Background

Conventional techniques for applying a liquid to a substrate include roll coating, spin coating, curtain flow coating, bar coating, meniscus coating, and so forth.

In the conventional device for applying liquid to a relatively short substrate through the use of a roller, the liquid is transferred from a grooved rubber roller to the substrate. Since the device is more appropriate for applying liquid in the form of a thin layer or applying the liquid to a large area, the device is used for the patterning of an electrode of a solar battery or the like. However, such a device has a problem in that the flatness of the applied film is poor because the liquid is applied from the grooves of the roller to the substrate. Additionally, the device has another problem in that pin holes are likely to be formed in the film of the applied liquid. For these reasons, the device is not often used for high-accuracy application such as to a substrate for an integrated circuit.

In the conventional device for applying the liquid to the relatively short substrate by spinning, the liquid can be accurately applied thereto to form a thin layer on the substrate. For that reason, the device has been widely used for the application of a photoresist to a semiconductor wafer. However, the device has a problem in that a photoresist cannot be uniformly applied to the entire surface of a side of the wafer having a large size by such a device. Further, since the effectively used quantity of the liquid applied onto the substrate is only a small percentage of the total amount of the dropped liquid, the economic efficiency is low if the cost of the liquid is high.

The conventional device for applying the liquid to the relatively short substrate utilizing a curtain-like flow is appropriate for the application of a liquid to a large substrate. However, since it is difficult to apply a thin film, the use of such a device is confined to applying a liquid such as a solder resist where a thick film of the liquid is required.

In the conventional device for applying the liquid to the top of the relatively short substrate through the use of a coating bar, a bar composed of a rod and a thin wire wound thereon is used to apply the liquid to the substrate. Although the liquid needs to be supplied with an appropriate quantity at the beginning of the application or during the application, it is difficult to constantly feed the liquid by the appropriate quantity. Further, the pattern of the feed of the liquid at the beginning of the application results in non-uniform application. Furthermore, the surplus portion of the liquid drops down from the side edges or rear edge of the substrate during the application or at the end of the application so as to contaminate the substrate or equipment around it.

The conventional device for applying the liquid to the relatively short substrate with the generation of menisci was disclosed in the U.S. Patent No. 4,370,356. However, since the quantity of the applied liquid depends on the properties of the liquid and the speed of the application, it is difficult to apply a uniform film of liquid. Additionally, a thin film cannot be applied unless the speed of the application is very low.

An improved bar coater is disclosed in the U.S. Patent No. 4,263,870 as one of the method for applying a liquid in the form of uniformly thin film to a flexible continuous film, i.e. web. In this method, since it is important to keep the bar perfectly in contact with the web, this is attained by causing the web to be lapped around the bar at a proper angle (usually 15° - 60°). However, in the case that a liquid is applied to a relatively short substrate, it is impossible to wrap the substrate around the bar by the tension which is applied to the substrate in a longitudinal direction thereof since the substrate is rigid and discontinuous in the form of pieces of sheet.

In order to adapt the bar coater disclosed in the USP 4,263,870 for applying a liquid to the relatively short substrate, the present inventors performed the application in which a liquid was applied to the substrate in a state that the substrate was held in a horizontal position and the substrate was depressed against the bar by a pressing member. As a result, the application was possible, however, there were the following serious problems in the application.

A first problem is that a loss distance between the beginning of the application and a portion where the thickness of the film formed on the substrate is uniform is large in length in the range of 2 cm to 5 cm.

The distance can be neglected in the case of the continuous travelling web because the continuous web has a sufficient length. Usually, the length of one roll thereof is more than 500 m, and some rolls have the length more than 10,000 m.

In the case where the liquid is applied to the relatively short substrate of which a length is in the range up to 2 m, the substrate suffers from the "loss distance" since each substrate has the loss portion at its leading portion.

A second problem is that longitudinal coating streaks are tend to occur on the substrate. The occurrence of the streaks is a fatal problem in quality.

## Summary of the Invention

The present invention was made in order to solve the above-mentioned problems of the conventional application devices.

Accordingly, it is an object of the present invention to provide a device for applying a liquid to a relatively short substrate, in which the liquid can be uniformly applied to the substrate in a state that the substrate is kept in a horizontal position, and non-uniformly applicating portion formed at the beginning of the applied substrate can be reduced.

The present inventors have studied with respect to the above-noted problems encountered when the bar disclosed in the USP 4,263,870 is adapted for the application to the relatively short substrate. As a result, they have found that it is possible to solve the above-noted problems due to the fact that a difference between the height of the fed liquid at the time of the stoppage of the rotation of the bar and that of the top of the bar is set in the range between 0.5 mm and 4.5 mm.

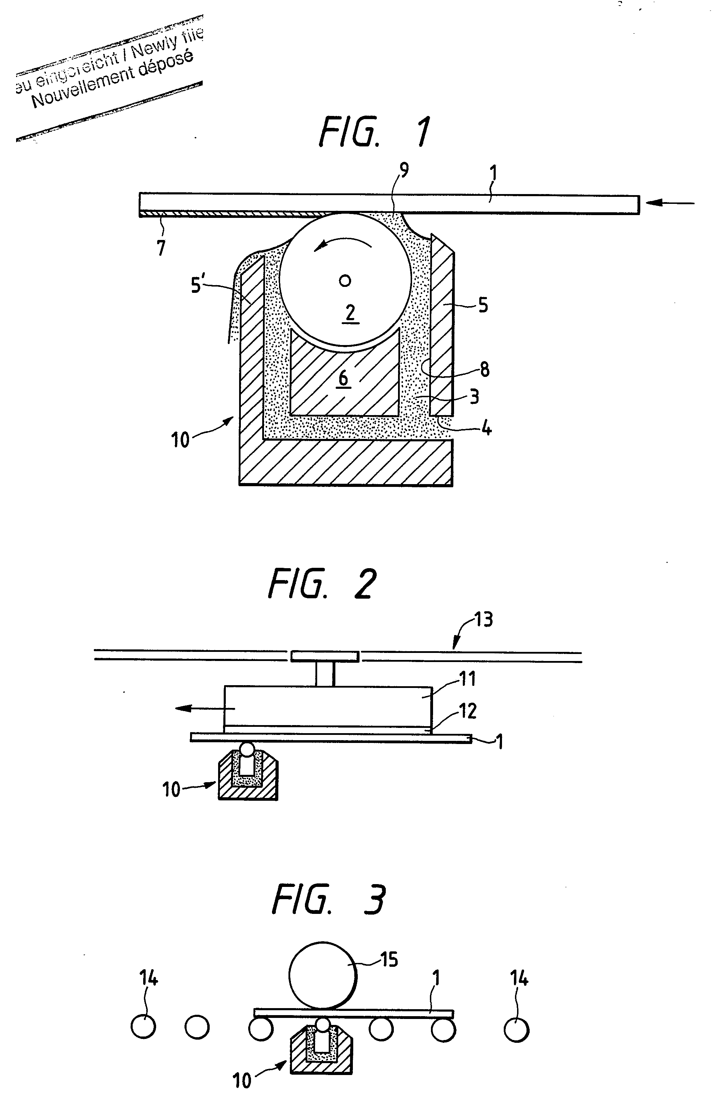

The height of the fed liquid is defined by the height of the weir member (the lower one of the weir members 5 or 5' in Fig. 1).

In case of applying the liquid to the continuously travelling web, the difference between the height of the fed liquid and that of the top of the bar is usually set in the range of 4.6 mm - 8 mm. The web is wrapped around the bar and conveyed along a slanted locus. Due to the fact that this difference range are needed in the case of continuously travelling web so as to avoid the contact of the web with any part of the weir members even if wrinkles are formed on the web in front of or behind the bar.

The present inventors found that, in the case of the relatively short substrate, the difference between the height of fed liquid and that of the top of the bar at the time of the stoppage of the rotation of the bar, should not be set at more than 4.6 mm.

If it is set to be more than 4.6 mm, it takes much time to make the meniscus stable since the meniscus formed in the proximity of the contacting portion becomes large in volume. As a result, the distance from the beginning of the application to the portion where the liquid is applied in the form of a film having uniform thickness is obtained must be long in length. Further, even if the stable meniscus is formed, longitudinal coating streaks are likely to occur since the shape of the meniscus does not become uniform with respect to the direction of the width of the substrate.

On the other hand, in the case in which the liquid is applied on the continuous long web, the ratio of the loss portion to the whole web is extremely low. In this case, the loss portion can be neglected.

Further, in the case of the continuous web, the liquid accumulation formed in the proximity of the contacting portion of the web with the bar is some what smaller in volume than the accumulation formed in the case of the substrate since the web is wrapped around the bar. Therefore, the shape of the accumulation is likely to become relatively uniform with respect to width direction of the web.

Furthermore, in the case of such a web, while the web contacts in area with the bar (in the case of the substrate, the substrate contacts in line with the bar), the shape of the liquid accumulation has almost no affect against the uniformity of the quantity of the applied liquid.

The device provided according to the present invention for applying a liquid to a relatively short substrate in a state that the substrate is kept horizontally between the coating bar and a suppressing member is characterized in that a deference between the height of the fed liquid during the stoppage of the rotation of the bar and the height of the top of the bar is provided in the range of 0.5 mm - 4.5 mm, the bar is kept in contact with the substrate, the liquid is fed so as to form the liquid accumulation immediately in front of the contacting portion of the bar, which is rotated in the same direction of that the substrate is conveyed and the liquid is applied to the substrate by the use of the bar.

## BRIEF DESCRIPTION OF THE DRAWINGS

In the accompanying drawings:
Fig. 1 is a schematic view of a bar application device which is an embodiment of the present invention;

Fig. 2 is a schematic view of a substrate conveyor including a suction means;

Fig. 3 is a schematic view of a substrate conveyor including passage rollers and a pressing roller;

Fig. 4 is a perspective view of a notched bar;

Fig. 5 is an explanatory view indicating the position of the surface of a liquid accumulation at the time of the stoppage of the bar of the application device, and

Fig. 6 is a perspective view showing an application device in which a bar of which grooves are filled at both ends is used.

## DETAILED DESCRIPTION OF THE INVENTION

An embodiment of the present invention is hereafter described with reference to the drawings attached hereto. Fig. 1 is a schematic view of a device 10 for applying a liquid 3 to a relatively short substrate 1 through the use of a bar 2 horizontally and rotatably supported throughout the total length thereof or at a part of the length by a bar support member 6. One end of the bar 2 is coupled to a drive motor (not shown). Weir members 5 and 5' are provided outside the bar support member 6 so that the liquid 3 fed through a liquid feed port 4 provided in a portion of the weir member 5 causes liquid storage portion 8 between the weir member and the bar support member. The substrate 1 is horizontally conveyed in the same direction as the rotation of the bar 2 so that the bottom of the substrate comes into contact with the top of the bar. As shown in Fig. 1, the rotating bar 2 lifts the liquid 3 from the liquid storage portion 8 so that the liquid creates liquid accumulation 9 on the bottom of the substrate 1 and is transferred thereto, and the bar 2 then removes the surplus portion of the transferred liquid. A film 7 of prescribed thickness is thus applied on the bottom of the substrate 1.

The above-mentioned conveyance of the substrate 1 may be performed by each of various means. For example, the conveyance may be performed by a substrate conveyor 13 having a suction unit 11 for conveying the substrate 1 as the suction unit, suctioning the top of the substrate, is moved as shown in Fig. 2. The conveyance may be otherwise performed so that the suction means 11, suctioning the substrate 1, is fixed and the application device 10 is horizontally moved relative to the substrate.

It is important to place the substrate 1 into tight contact with the bar 2 throughout the total width of the substrate to uniformly apply the liquid to the substrate. For that purpose, an elastic porous body 12 is interposed between the suction means 11 and the substrate 1 to urge the substrate against the bar 2 under uniform pressure throughout the total width of the substrate, as shown in Fig. 2.

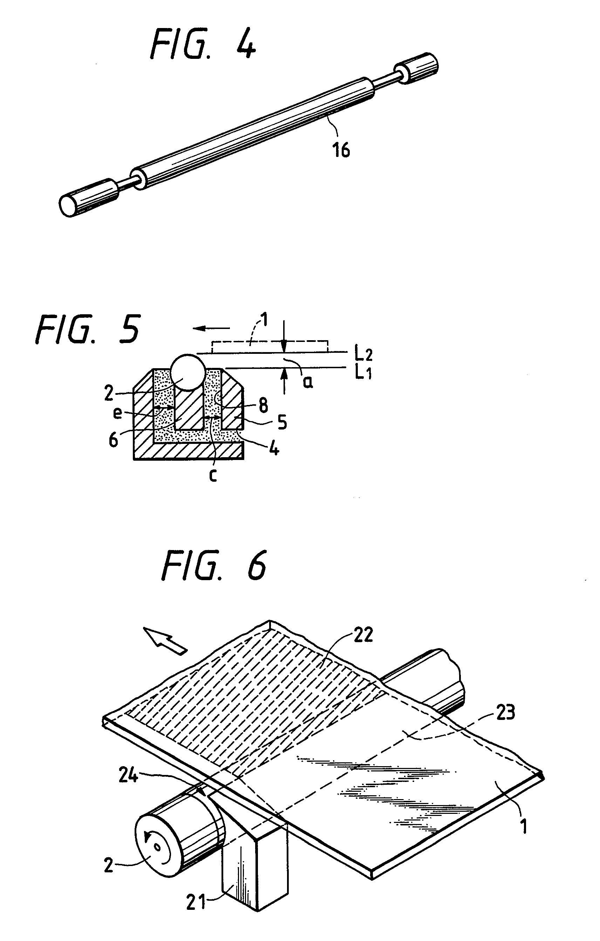

The substrate 1 may also be horizontally conveyed to the application device 10 by passage rollers 14 and a hold-down roller 15 as shown in Fig. 3. It is preferable that the outer edges of the passage rollers 14 have an enlarged diameter such that substrate is conveyed on the outer widthwise portions so as to minimize the area of the contact of each passage roller and the bottom of the substrate 1. If the side edges of the passage rollers 14 have the enlarged diameter, a notched bar 16 having notches near both the ends of the bar, as shown in Fig. 4, is provided, instead of the bar 2, to prevent the application of the liquid 3 to the side edges of the substrate 1 where the enlarged diameter portions of the rollers 14 contact the substrate 1 so as to prevent the passage rollers 14 from becoming contaminated with the film of the already applied liquid on the substrate. In order to prevent the passage rollers 14 from becoming contaminated with the film of already applied on the substrate, it is also preferable that a bar in which wire grooves of portions kept in contact with both ends of the substrate are filled with solder is provided instead of the bar 2 and blades 21 for removing a liquid applied on the surfaces of the portions are provided, as shown in Fig. 6. It is preferable that the hold-down roller 15 have an elastic material such as rubber on the surface of the body of the roller to maintain the substrate 1 into tight contact with the notched bar 16 throughout the total width of the substrate. In addition, in Fig. 6, numeral reference 21 denotes a blade; 22, a liquid applied surface of the substrate; 23, a wiring portion; and 24, a portion in which wire grooves are filed with solder.

It is important to maintain the liquid accumulation 9 in an optimal form to uniformly apply the liquid 3 to the substrate 1. Since the substrates 1 are intermittently conveyed to the application device 10 for the application of the liquid 3 to each substrate, the liquid accumulation 9 is intermittently formed. Therefore, the liquid accumulation 9 needs to be formed in a stable state at the same time as the contact of the substrate 1 with the bar 2. For that reason, the difference "a" between the height $L_1$ of the liquid 3 during the stoppage of the rotation of the bar 2 and the height $L_2$ of the top of the bar, as shown in Fig. 5, is set at 0.5 mm to 4.5 mm, preferably at 1.0 mm to 4.0 mm. As a result, the liquid accumulation 9 is quickly formed in a stable state at the time of the contact of the substrate 1 with the bar 2. If the difference "a" were larger than 4.5 mm, it would take more time to form the liquid accumulation 9 in the consistent state and the thickness of the film of the applied liquid 3 on the substrate 1 at the front edge thereof would likely become unstable and cause longitudinal coating streaks. If the difference "a" were smaller than 0.5 mm, the liquid accumulation 9 would likely become larger to make the application of the liquid 3 non-uniform.

The height of the weir member 5 is appropriately adjusted so as to make the above-noted difference "a" be in the predetermined range (i.e., the desired height of the liquid). In this case, it is possible to easily maintain the weir member in the desired height of the liquid while some liquid overflows after the height of the weir member is set at the same level as the desired height of the liquid. It is, however, noted that if the liquid-overflow is prevented for the purpose of saving the liquid, the height of the weir member 5 can be set exceeding the desired height of the liquid. In this case, the quantity of the supplying liquid should be controlled by the liquid level detected by the rotation of the bar. If the applied liquid is caused to overflow, except for the case in which the liquid is excessively supplied, the overflow does not occur uniformly from whole width but does occur partially. In this case, due to a kind of the applied liquid, a non-uniform film having streak portions is likely to appear at the overflow portion. As shown in Fig. 1, in order to limit the overflow portion, it is effective that the wire member disposed in front of the bar is different in height from that disposed behind the bar so as to overflow the liquid from the weir member having the lower height. It is also effective that the weir member is provided with a portion having the lower height than that of the other portion. The lower height portion is preferably disposed out of the surface to which liquid is applied.

As shown in Fig. 5, distances c and e between the weir member and the bar can be also determined appropriately. If the distances c and e are large, no problem is encountered in the application. However, this is not preferable so that the coater becomes large in size and the liquid stored in the coater becomes large in quantity. In other words, if the distance c is too narrow, it is difficult to form the stable liquid accumulation because the liquid to be applied on the substrate partially flows over the weir member from the liquid accumulation 9. Also, if the distance e is too narrow, it is not preferable because the decrease of the liquid level at the downstream side due to the rotation of the bar tends to cause the entrained air in the liquid around the bar.

As a result, the distance c and e should be set in the range of 3 mm - 20 mm.

It is preferable that the bar be made of a metal, particularly a stainless steel, to be high enough in mechanical strenth and resistance to chemicals. However, if the strength of the surface of the substrate 1 is so low that the surface is likely to be damaged by the bar 2, the bar may be made fiber with a plastic such as nylon wound therearound. Alternatively, the bar may be a grooved bar made of rubber or plastic or a lapping bar whose outside circumferential surface is smoothly polished to increase the area of the contact of the surface of the bar and the substrate. The diameter of the bar 2 is set at 3.0 mm to 30.0 mm, preferably at 5.0 mm to 20.0 mm. If the diameter were larger than 30.0 mm, the film of the applied liquid 3 would be non-uniform so as to have a longitudinal ridge. If the diameter is smaller than 3.0 mm, it would be difficult to manufacture the bar 2. If the bar having the fiber wound on the body of the bar is used instead of the bar 2, the diameter of the fiber is predetermined depending on the thickness of the film of the applied liquid 3. If the cross-section of the fiber is circular and the speed of the conveyance of the substrate 1 is equal to the circumferential velocity of the bar, the thickness of the wet film of the applied liquid 3 is determined in accordance with a formula as follows:

$t = 70d$; where

t and d denote the thickness ($\mu$) of the wet film and the diameter (mm) of the fiber, respectively. The diameter of the fiber is set at 0.05 mm to 1.0 mm, preferably at 0.05 mm to 0.7 mm, to make the surface of the film of the applied liquid 3 sufficient.

If the grooved bar of rubber or plastic is used instead of the bar 2, the interval between the grooves of the bar is set at 1 mm or less, preferably 0.7 mm or less. It is appropriate that the cross-section of each of the grooves is shaped nearly as a sine curve. However, the cross-section is not confined thereto.

It is known that the thickness of the wet film of the liquid 3 applied to the substrate 1 through the use of the grooved bar or the lapping bar depends on the per-unit-length volume of the space present between the bottoms of the recesses of the bar and the virtual straight line extending along the top of the projections of the bar and is nearly equal to that of the wet film of the liquid applied to the substrate through the use of the bar having the fiber wound on the body of the bar. One of these bars, which has appropriate form and dimensions for the application of the liquid 3 to the substrate 1, may be optionally used instead of the bar 2. The application of the liquid 3 to the substrate 1 can thus be stably performed ranging from the application of the liquid to make a thin film whose quantity of the liquid is about 4 cc/m², to that of the liquid to make a thick film whose quantity of the liquid is about 70 cc/m².

The speed of the application of the liquid 3 to the substrate 1 is set at 0.1 m/min. to 20 m/min., preferably at 0.2 m/min. to 10 m/min., from the viewpoint of the quality of the surface of the film of the applied liquid and the manipulation of the application device 10. It is preferable that the circumferential velocity of the bar 2 be equal to the speed of the conveyance of the substrate 1 because no slippage will occur therebetween. In the case where the surface of the substrate 1 is not damaged by slippage between the bar 2 and the substrate, the surface of the film of the liquid 3 can be improved by lowering the circumferential velocity of the bar as long as the liquid accumulation 9 is kept stable.

The substrate 1 applied the liquid is not limited. For example, papers, plastic films, resin coating papers and substrate made of metal or glass can be used in the application device according to the present invention. Each thickness of those is not limited; however, it is preferable to use the substrate or the paper having the thickness in the range of 0.1 mm - 10 mm.

The size of the substrate 1 is not particularly limited. Although the flatness of the substrate 1 is usually likely to be low if the substrate is made of glass and large in size, it is confirmed that the liquid 3 can be uniformly applied to a square substrate made of glass and having a size of 2 mm in thickness, 1 m in length and 1 m in width, if the hold-down roller 15 shown in Fig 3 and having the elastic material on the surface of the body of the roller is used for the application device 10. The form of the substrate 1 is not particularly limited. The liquid 3 can be applied to the substrate 1 by the device 10, whether the substrate is shaped as a square, a circle or others.

It is possible to apply any kind of liquid on the relatively short substrate by the application device according to the present invention. Neither the composition or physical properties of the liquid is particularly limited; however, it is preferable to apply the liquid having viscosity less than 100cp, particularly 50cp.

An actual example of an embodiment of the present invention is hereafter described to clarify the effect of the invention. In the example, a photoresist liquid was applied to a substrate of glass having a size of 30 cm in length, 30 cm in width and 1.1 mm in thickness through the use of both the bar application device 10 shown in Fig 1 and a substrate conveyor 13 shown in Fig. 2 and including the suction means 11 and the elastic porous body 12. The bar 2 of the device 10 was composed of a stainless steel rod of 12.7 mm in diameter and stainless steel wires having diameters of 0.1 mm and 0.2 mm wound around the rod. The difference "a" between the height $L_1$ of the fed photoresist liquid at the time of the stoppage of the rotation of the bar 2 and the height $L_2$ of the top of the bar, as shown in Fig. 5, was maintained at 2 mm. The speed of the conveyance of the substrate to the device 10 by the conveyor 13 was equal to the circumferential velocity of the rotating bar 2 and set at 1 m/min., 3 m/min. and 5 m/min., at each of which the surface of the film of the applied liquid on the substrate was good and longitudinal coating streaks did not occur.

An application device provided in accordance with the present is suitable for applying a liquid to a relatively short substrate to make a thin film of the liquid thereon. The quantity of the applied liquid is not affected by the physical properties of the liquid and can be kept stable. The uniformity of the film of the applied liquid is high. Any pinhole is not made in the film.

Particularly, in the device of the present invention, since the portion to which the liquid is not applied uniformly at the beginning of the application can be extremely reduced to, for example, 5 mm or less, even if the length of the substrate is less than 2 mm, the applied substrate can effectively be produced. Further, since the application can be performed in the state that the substrate is kept horizontally, the device is suitable for the substrate which is rigid and not flexible.

Therefore, the application of a photoresist to a semiconductor wafer, that of a photoresist for a photographic mask for the production of a semiconductor wafer, that of a solder resist to a printed circuit board, that of a liquid to a substrate of glass and so forth can be also uniformly performed by the device even if the semiconductor wafer, the printed circuit board, the substrate and so forth have a large size and an arbitrary form. Since the loss of the liquid fed to be applied to the substrate is small, the economic efficiency of the device is high.

## Claims

1. A device for applying a liquid to a substrate, comprising:

a cylindrical bar, said bar being rotatably supported in contact with a side of said substrate;

means for pressing said substrate against said bar;

means for conveying said substrate in a state that said substrate is kept in a horizontal position between said bar and said pressing means;

means for rotating said bar such that the outer circumferential portion of said bar, in contact with said substrate, moves in the same direction as said substrate; and

means for supplying liquid proximate said bar such that rotation of said bar lifts said liquid so as to create a menisci on said side of said substrate immediately upstream to the location where said contact occurs such that said liquid is applied to said substrate, wherein the difference (a) between the height (L1) of the surface of the supplied liquid at the time of the stoppage of the rotation of the bar and the height (L2) of the top of said bar is set at 0.5 mm to 4.5 mm.

2. The device of claim 1, wherein said conveyance means comprises:
suction means for suctioning said substrate; and
means for conveying said suction means.

3. The device of claim 2, further comprising an elastic porous member interposed between said suction means and said substrate so as to uniformly press said substrate against said bar.

4. The device of claim 1, wherein said conveyance means comprises a plurality of conveyance rollers and a hold-down roller disposed on opposing sides of said substrate.

5. The device of claim 4, wherein the outer portions of said conveyance rollers have a diameter larger than the central portion thereof such that said substrate is conveyed on the outer width-wise portions thereof so as to minimize contact between said rollers and said substrate.

6. The device of claim 5, wherein said bar has notches having a reduced diameter on the outer portions thereof in correspondence with the large diameter of the outer portions of said conveyance rollers such that liquid is not applied to the outer width-wise portions of said substrate where said conveyance rollers contact said substrate.

7. The device of claim 6, wherein the front, bottom portion of said substrate is chamfered.

8. The device of claim 1, wherein the diameter of said bar is between 6.0 mm and 30.0 mm.

9. The device of claim 1, wherein said bar has a circular cross-section and has a plastic fiber wound therearound, the diameter of said fiber ranging from 0.05 mm to 1.0 mm.

10. The device of claim 9, wherein the thickness of the applied film is proportional to the diameter of the fiber as follows:
$t = 70d;$
where t is the thickness ($\mu$) of the applied film and d is the diameter (mm) of the fiber.

11. The device of claim 1, wherein said pressing means comprises a pressing roll and said conveyance means comprises pass rolls disposed in front of and behind said bar, said substrate being conveyed on said pass rolls between said bar and said pass roll.

12. The device of claim 1, further comprising;
means for carrying said pressing means in a horizontal direction above said bar.

# FIG. 1

# FIG. 2

# FIG. 3

*FIG. 4*

16

*FIG. 5*

1

L2
L1

2
e
6
8
5
4

a

c

*FIG. 6*

22

23

24

2

21

1